(19) Europäisches Patentamt / European Patent Office / Office européen des brevets

(11) **EP 3 792 832 B1**

(12) **EUROPEAN PATENT SPECIFICATION**

(45) Date of publication and mention
of the grant of the patent:
**16.04.2025 Bulletin 2025/16**

(51) International Patent Classification (IPC):
**G06N 3/042** (2023.01)      **G06N 7/01** (2023.01)
**G06N 5/01** (2023.01)      **G06N 3/084** (2023.01)
**H03M 13/11** (2006.01)      **G06N 3/045** (2023.01)

(21) Application number: **19196769.4**

(22) Date of filing: **11.09.2019**

(52) Cooperative Patent Classification (CPC):
**G06N 3/084; G06N 3/042; G06N 5/01; G06N 7/01;**
**H03M 13/1111;** G06N 3/045

(54) **BELIEF PROPAGATION WITH NEURAL NETWORKS**

GLAUBENSPROPAGATION MIT NEURONALEN NETZWERKEN

PROPAGATION DE CROYANCES À L'AIDE DE RÉSEAUX NEURONAUX

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**17.03.2021 Bulletin 2021/11**

(73) Proprietor: **Robert Bosch GmbH
70442 Stuttgart (DE)**

(72) Inventors:
• **Welling, Max
   1402GN Bussum (NL)**
• **Akata, Zeynep
   1019 VK Amsterdam (NL)**
• **Garcia Satorras, Victor
   1055 AA Amsterdam (NL)**
• **Zhang, Dan
   71229 Leonberg (DE)**

(56) References cited:
• **F. LIANG, C. SHEN: "An iterative BP-CNN
   architecture for channel decoding", IEEE
   JOURNAL OF SELECTED TOPICS IN SIGNAL
   PROCESSING, vol. 12, no. 1, 15 January 2018
   (2018-01-15), pages 144 - 159, XP011678175, DOI:
   10.1109/JSTSP.2018.2794062**

• **V. GARCIA SATORRAS ET AL: "Combining
   generative and discriminative models for hybrid
   inference", ARXIV.ORG, CORNELL UNIVERSITY
   LIBRARY, 201 OLIN LIBRARY CORNELL
   UNIVERSITY ITHACA, NY 14853, 20 June 2019
   (2019-06-20), XP081373894**

• **K. YOON ET AL: "Inference in probabilistic
   graphical models by graph neural networks",
   ARXIV.ORG, CORNELL UNIVERSITY LIBRARY,
   201 OLIN LIBRARY CORNELL UNIVERSITY
   ITHACA, NY 14853, 27 June 2019 (2019-06-27),
   XP081380054**

• **Z. ZHANG ET AL: "Factor graph neural network",
   ARXIV.ORG, CORNELL UNIVERSITY LIBRARY,
   201 OLIN LIBRARY CORNELL UNIVERSITY
   ITHACA, NY 14853, 3 June 2019 (2019-06-03),
   XP081372003**

**Description**

**FIELD**

The presently disclosed subject matter relates to a computer-implemented method for estimating a plurality of random variables, a neural-network system for estimating a plurality of random variables, and a computer readable medium.

**BACKGROUND**

In many areas of computer science it is needed to reason about so-called random variables, e.g., random values that satisfy some joint probability distribution. For example, in the field of electronic communication a receiver may wish to know what data was sent to him by a sender. The data that the receiver received, e.g., through a cable or an antenna, may be distorted during transition on the communication channel, e.g., by noise. The receiver may represent the data that was sent by random variables, and proceed to reason about the random variables based on the data that was received, an estimate of the noise on the communication channel, and an error correction code that may have been used by the sender. As a result of such an estimation, the sender may obtain an estimate of the bits that were sent out. For example, such an estimate may be a hard estimate, e.g., particular one or zero values or a soft-estimate, e.g., probabilities assigned to the various possible bit-values. There are many further applications of random variables, some of which are further expanded upon herein.

A conventional way to reason about random variables, and to estimate their values, e.g., their probability distribution, is to use a graphical model. A graphical model is a structured representation of locally dependent random variables. The traditional method to reason over these random variables is to perform inference with message passing algorithms referred to as belief propagation. In message passing a plurality of belief-messages are defined which express information about the variables. By repeatedly updating these beliefs, or belief messages, it is hoped that the various beliefs about the variables, e.g., as inferred from observed information, becomes consistent with each other. In particular, in a graphical model, some nodes may represent variables, e.g., the variable nodes, and some nodes may represent local dependencies between variables, e.g., the factor nodes. Messages passing from variables nodes to factor nodes and vice versa, tries to ensure that information about factors and variables are shared until they form a consistent whole.

A particular example of a belief propagation algorithm is the sum-product message passing algorithm for performing inference on graphical models. Belief propagation is commonly used in artificial intelligence and information theory and has demonstrated empirical success in numerous applications including error decoding, in particular low-density parity-check codes and turbo codes, free energy approximation, satisfiability, noise removal, etc.

A particular important application of belief propagation is error correction of Low Density Parity Check codes (LDPC). An algorithm for error decoding may comprise running belief propagation in a particular loopy bipartite graph defined by the code and the communication channel. LDPC codes are for example employed in Wi-Fi communication, 5G communication, and so on.

Several disadvantages can be identified for conventional belief propagation methods. Belief propagation can be shown to converge provided the graph underlying the graphical model is a tree. In practice though, the graphs is not a tree but cyclic or loopy and belief propagation is not guaranteed to converge. Moreover, belief propagation assumes that it is provided with the true data generating process, e.g., an exact model of the communication channel from sender to receiver. However, in many cases one only has access to an approximation of the data generating process, and often a poor one at that. This leads to suboptimal estimates even if the repeated belief propagation converges. Since decoding LDPC codes are in fact belief propagation run in a loopy bipartite graph, they are not guaranteed to converge or to provide the correct estimates even when convergence occurs.

On 15 January 2018, Liang et al. "An iterative BP-CNN architecture for channel decoding", IEEE J. Sel. Top. Signal Process, vol. 12(1), pp. 144-159 proposed a novel iterative BP-CNN architecture for channel decoding under correlated noise. This architecture concatenates a trained convolutional neural network (CNN) with a standard belief-propagation (BP) decoder. The standard BP decoder is used to estimate the coded bits, followed by a CNN to remove the estimation errors of the BP decoder and obtain a more accurate estimation of the channel noise. Iterating between BP and CNN will gradually improve the decoding SNR and hence result in better decoding performance.

On 20 June 2019, Garcia Satorras et al "Combining generative and discriminative models for hybrid inference", arXiv:1906.02547v3, proposed a hybrid model that combines graphical inference with a learned inverse model, which we structure as in a graph neural network, while the iterative algorithm as a whole is formulated as a recurrent neural network.

On 27 June 2019, Yoon et al "Inference in probabilistic graphical models by graph neural networks" arXiv:1803.07710v5, proposed to use Graph Neural Networks (GNNs) to learn a message-passing algorithm that solves these inference tasks.

On 3 June 2019, Zhang et al "Factor graph neural network", arXiv:1906.00554v generalised the graph neural network into a factor graph neural network (FGNN) in order to capture higher order dependencies. The FGNN is defined using two types of modules, the Variable-to-Factor (VF) module and the Factor-to-Variable (FV) module. These modules are combined into a layer, and the layers can be stacked together.

**SUMMARY**

It would be advantageous to have improved methods to estimate random variables. The invention is defined in the independent claims. Preferred embodiments are defined in the dependent claims. In particular, a method for estimating a plurality of random variables is defined in the claims.

In an embodiment of such a method, belief messages are passed among nodes of a graphical model according to a belief propagation technique, which may be conventional belief propagation. Iteratively applying belief propagation round to the belief messages would, as is known in the art, converge to optimal estimates, provided the probability distribution of the data generation process would be perfectly known and that the graphical model would not be loopy. Unfortunately, neither assumption holds in practice. Accordingly, repeatedly applying a belief propagation round might not converge, and if it does converge it might not converge to the correct estimates.

Accordingly, the neural network rounds are performed between the rounds of belief propagation. In the neural network round, one or more neural networks operate on the belief messages, e.g., as generated by the belief propagation and adapt them to improve their convergence, e.g., to improve the likelihood that convergence happens at all and/or improve the values to which they converge. Interestingly, the neural network can steer the belief propagation away from states that diverge, or converge incorrectly. The belief propagation part depends on assumptions of the communication channel. Such assumptions are typically not known or wrong. However, the neural network rounds learn to take a real communication channel better into account. The neural network rounds thus supplement the belief propagation rounds. The hybrid model combines the high bias of graphical models with the high variance of neural networks. Although only using neural network rounds would be possible, the belief propagation rounds typically provide for quick dissemination of beliefs through the graphical model, and can provide quick convergence. The belief propagation rounds thus supplement the neural network rounds. Combining belief propagation rounds with neural network rounds was thus found to be advantageous, especially for difficult settings, e.g., high noise, noise dependencies and so on. Interestingly, combining the two types of rounds will not do worse than belief propagation on its own, since if it were, the neural networks will learn not to adapt the belief messages.

Once a sufficient number of rounds have executed, e.g., when convergence has occurred, or after execution for a predetermined number of rounds or amount of time, or the like, estimates are computed from the belief messages. This may be done according to a conventional method. In particular, a marginal probability distribution of the plurality of random variables may be computed from the belief messages.

Estimating random variables is applied to decoding, such as decoding an LDPC code word. The present invention is receiving a noisy codeword over a communication channel from a sender. The codeword as transmitted by the sender over the communication channel is represented by the plurality of random variables. Parity conditions in the codeword as transmitted being represented by local dependencies, e.g., by factor nodes. The received data is incorporated in the belief propagation rounds in various ways, e.g., in the form of coefficients that depend on the received information, e.g., weighing the belief messages, or in the form of so-called factor functions.

Once the belief propagation is complete the code word as transmitted is estimated. From the estimate one could extract the information-bits that were transmitted. For example, channel coding at the transmitter may encode information bits, which may each be mutually independent, to a codeword having correlations among bits to facilitate error correction at the receiver side. At the receiver, the observation of the codeword is noisy or corrupted by the communication channel. Belief propagation may be used to recover the information bits based on the code bits correlation, e.g., the parity check in LDCP, and the noisy observations. Neural network rounds among the belief propagation may be used to correct wrong assumptions about the communication channel, or to correct divergence.

The belief propagation rounds are alternated with the neural network rounds. This has the advantage that information learned in the belief propagation is quickly shared with the neural networks. For example, in an embodiment not covered by the claims, one could do two belief propagation rounds to a single neural network round. For example, in an embodiment not covered by the claims, one could start off the estimation with a fixed number of belief propagation rounds, e.g., three or four, before using neural network rounds too, etc.

Among the many types of neural networks that may be used, the present invention makes the advantageous choice of graph neural networks. A graph neural network (GNN), like a graphical model comprises multiple nodes. However, different from a graphical model is that the nodes and/or the edges between the nodes can carry information, on which one or more neural networks can act. The GNN is configured such that at least one different node of the GNN corresponds to each node of the graphic model. For example, one could define a one-to-one relation between the nodes of the GNN and of the graphic model.

In an embodiment, the one or more neural networks operate on the belief messages and on data specific to the GNN, e.g., latent node data, which may be defined for the nodes of the GNN. A neural network round may have two phases: in a first phase, current values for the latent node data and current values for the belief messages are used to update the latent node data and possibly latent edge data; in a second phase the updated the latent node data/or latent edge data is used to adapt the belief messages. The two phases may be implemented by one more different networks. Adapting a belief message may be done by computing correction data which can be added or the like to a belief message. Instead of adding a correction one my use different correction functions, e.g., multiplying a correction, or combining in an affine function, etc.

There are various ways in which the belief messages and the latent node data may be initiated. For example, the latent node data may be initiated randomly, e.g., with a random value in an interval. For example, the belief messages may be initiated uniformly.

As pointed out above, reasoning about random variables has many applications beyond error correcting codes. For example, in an embodiment not covered by the claims, data from one or more sensors is received, e.g., sensors that are placed in a technical system such as a motor, e.g., temperature or pressure sensors. There may be an interest in knowing other physical properties of the system for which there is no sensor. Moreover, the received values may be corrupted by noise, etc. In this case, random values may represent the true, uncorrupted sensor values or places without a sensor. Belief propagation may obtain the true state of the system. For example, sensors may obtain information from a traffic scene, e.g., one or more of location, velocity and orientation of traffic participants. Hidden variables, e.g., a destination of traffic participant, may be estimated from belief propagation combined with neural network rounds. In applications outside error correction, not covered by the claims, the probability model may be even worse than in communication so that the neural network round may be even more advantageous.

Training the neural network may be done by applying the method to received data for which ground truth is available. For example, the system may be run for a fixed number of rounds, after which a loss function is back propagated. The loss function may comprise a difference between an estimate of the method and the ground truth. Any suitable training procedure may be used, e.g., back propagation, Adam, etc. Training may use batches, etc.

The present invention also concerns a neural-network system for estimating a plurality of random variables. The system may be distributed over multiple devices, but may be also be implemented in a single device. The system comprises a processor system configured for a method according to the invention. The neural-network system comprises a communication interface for noisy codeword, which may be error corrected using a combination of belief propagation and neural network rounds. After the rounds are finished, the code word is decoded, to obtain data bits, etc.

The system may be implemented in one or more electronic devices, e.g., server, set-top box, smart-card, television, camera, computer, etc. The system may be implemented in a mobile electronic device, e.g., a mobile phone, or a laptop.

The present invention also concerns a computer readable medium comprising data representing instructions, which when executed by a processor system, cause the processor system to perform a method according to the invention.

The medium may be transitory or non-transitory.

In addition to the applications in communication, the methods described herein may be applied in a wide range of practical applications, that are not covered by the claims, such as image processing, autonomous machines, including autonomous driving machine, including self-driving cars.

The method is implemented on a computer as a computer implemented method, or in dedicated hardware, or in a combination of both. Executable code for an embodiment of the method is stored on a computer program product. Examples of computer program products include memory devices, optical storage devices, integrated circuits, servers, online software, etc. The computer program product comprises non-transitory program code stored on a computer readable medium for performing the method when said program product is executed on a computer.

The computer program comprises computer program code adapted to perform the steps of the method when the computer program is run on a computer. The computer program is embodied on a computer readable medium.

Another aspect of the presently disclosed subject matter is a method of making the computer program available for downloading. This aspect is used when the computer program is uploaded into, e.g., Apple's App Store, Google's Play Store, or Microsoft's Windows Store, and when the computer program is available for downloading from such a store.

## BRIEF DESCRIPTION OF THE DRAWINGS

Further details, aspects, and embodiments will be described, by way of example only, with reference to the drawings. Elements in the figures are illustrated for simplicity and clarity and have not necessarily been drawn to scale. In the figures, elements which correspond to elements already described may have the same reference numerals. In the drawings,

Figure 1a schematically shows a neural-network system for estimating a plurality of random variables,
Figure 1b schematically shows a neural-network system for estimating a plurality of random variables,
Figure 1c schematically shows a neural-network system for estimating a plurality of random variables,

**EP 3 792 832 B1**

Figure 1d schematically shows a neural-network system for estimating a plurality of random variables,
Figure 2a schematically shows a graphical model,
Figure 2b schematically shows a graphical model,
Figure 2c schematically illustrates a method for estimating a plurality of random variables,
Figure 3a schematically shows a neural-network system for estimating a plurality of random variables,
Figure 3b schematically shows a neural-network system for estimating a plurality of random variables,
Figure 4 schematically shows a neural-network system for estimating a plurality of random variables,
Figure 5 schematically shows a method for estimating a plurality of random variables,
Figure 6 schematically shows a method for training one or more neural networks,
Figure 7a schematically shows a computer readable medium having a writable part comprising a computer program.
Figure 7b schematically shows a representation of a processor system.

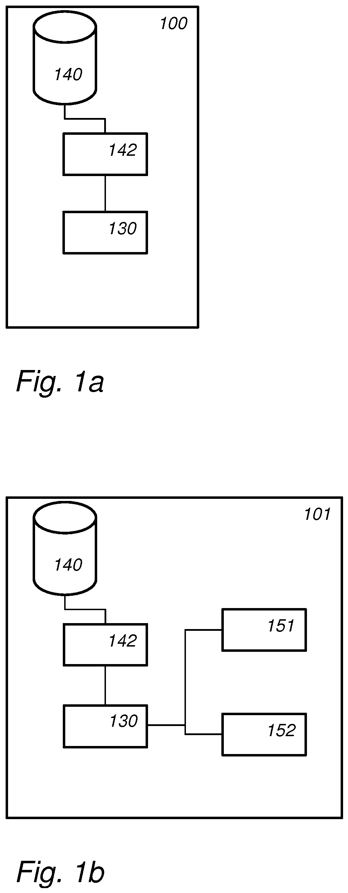

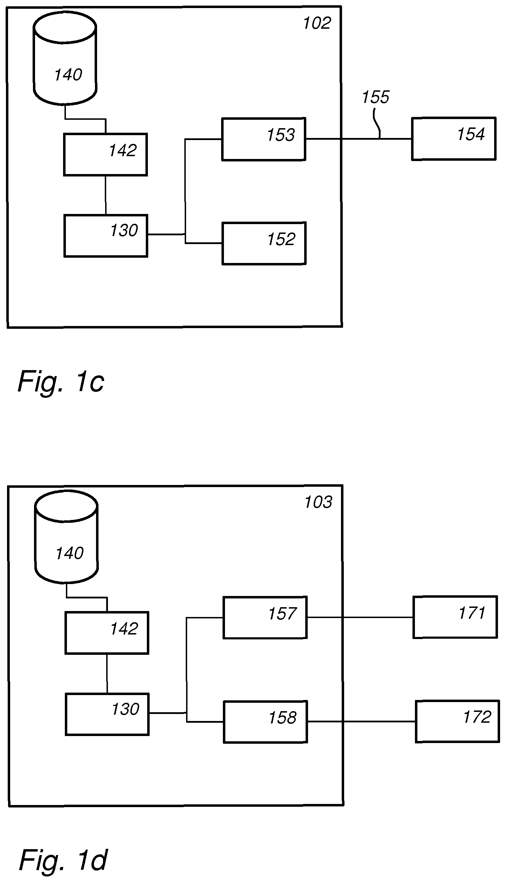

List of Reference Numerals in figures 1-4,7a-7b:

| | |
|---|---|
| 100-103 | a neural-network system for estimating a plurality of random variables |
| 140 | a storage |
| 142 | a storage interface |
| 130 | a processor system |
| 151 | an input interface |
| 152 | an output interface |
| 153 | a communication interface |
| 154 | a sender |
| 155 | a communication channel |
| 157 | a sensor interface |
| 158 | an actuator interface |
| 171 | a sensor system |
| 172 | an actuator system |
| 200-201 | a graphical model |
| 211-212 | a factor node |
| 221-226 | a factor node |
| 231-232 | a variable node |
| 242 | a transition from a belief propagation round to a neural network round |
| 243 | a transition from a neural network round to a belief propagation round |
| 300, 301, 302 | a neural-network system for estimating a plurality of random variables |
| 320 | a neural network function |
| 321 | adaptation data |
| 330 | a belief propagation function |
| 331 | refined belief messages |
| 332 | a belief messages adaptation |
| 341, 343, 345 | latent node data |
| 342, 344, 346 | belief messages |
| 322 | an edge to node function |
| 324 | a node to edge function |
| 326 | an edge to belief function |

| | |
|---|---|
| 1000 | a computer readable medium |
| 1010 | a writable part |
| 1020 | a computer program |
| 1110 | integrated circuit(s) |
| 1120 | a processing unit |
| 1122 | a memory |
| 1124 | a dedicated integrated circuit |
| 1126 | a communication element |
| 1130 | an interconnect |
| 1140 | a processor system |

## EP 3 792 832 B1

## DETAILED DESCRIPTION OF EMBODIMENTS

While the presently disclosed subject matter is susceptible of embodiment in many different forms, there are shown in the drawings and will herein be described in detail one or more specific embodiments, with the understanding that the present disclosure is to be considered as exemplary of the principles of the presently disclosed subject matter and not intended to limit it to the specific embodiments shown and described.

In the following, for the sake of understanding, elements of embodiments are described in operation. However, it will be apparent that the respective elements are arranged to perform the functions being described as performed by them.

Further, the presently disclosed subject matter is not limited to the embodiments, as feature described herein or recited in mutually different dependent claims.

**Figure 1a** schematically shows a neural-network system 100 for estimating a plurality of random variables. Estimating random variables is a core feature of many technical applications, varying from error correction, noise reduction to, though not covered by the claims, scene analysis for autonomous devices.

System 100 comprises a processor system 130, a storage 140. System 100 further comprises a storage interface configured for interfacing between processor system 130 and storage 140.

Storage 140 may be a local storage of system 110, e.g., a local hard drive or memory. Storage 140 may be non-local storage, e.g., cloud storage. In the latter case, storage 140 may be implemented as a storage interface to the non-local storage. For example, storage interface may comprise a local interface such as a hard drive interface, a memory interface or the like, or a non-local interface, such as network interface, e.g., configured to interface to cloud storage. Storage 140 may be a hybrid comprising local and non-local storage. For example, computer instructions may be stored locally, e.g., in an electronic memory or other electronic storage, and data, e.g., training data, input data, etc., may be stored non-locally.

Storage 140 comprises computer instructions for execution by processor system 130. Storage 140 may comprise parameters for machine learnable functions, such as neural networks. Storage 140 may comprise training data for training the machine learnable functions. System 100 may be configured for a training phase, in which training data may be used, and in which training algorithms such as back propagation may be stored in storage 140. System 100 may be configured for a use phase, in which training data and algorithms might not be stored in storage 140.

The execution of system 100 is implemented in a processor system, e.g., one or more processor circuits, e.g., microprocessors, examples of which are shown herein. For example, the functional elements or units, etc. of embodiment may be wholly or partially implemented in computer instructions that are stored at system 100, e.g., in storage 140, e.g., in an electronic memory of system 100, and which are executable by a microprocessor of system 100 or the like. In hybrid embodiments, functional units may be implemented partially in hardware, e.g., as coprocessors, e.g., neural network coprocessors, and partially in software stored and executed on system 100. Parameters of the network and/or training data may be stored in storage 140.

System 100 may communicate internally, or externally, e.g., with external storage, input devices, output devices, and/or one or more sensors over a computer network. The computer network may be an internet, an intranet, a LAN, a WLAN, etc. The computer network may be the Internet. System 100 may comprise a connection interface which is arranged to connect to the computer network, e.g., to communicate within the system or outside of the system as needed. For example, the connection interface may comprise a connector, e.g., a wired connector, e.g., an Ethernet connector, an optical connector, etc., or a wireless connector, e.g., an antenna, e.g., a Wi-Fi, 4G or 5G antenna. The computer network may comprise further elements, e.g., a router, a hub, etc.

The system 100 comprises a communication interface. The communication interface may be used to receive digital commands. The command may instruct system 100 to start estimating random variables, start a training, and the like. The commands may be digital packets, e.g., received in electronic form.

System 100 is configured according to an embodiment. The input data comprise of a received noisy codeword (and may further comprise sensor data, a noisy image, etc.) that is received in storage 140 or through some other interface. The output data comprise one or more estimated random variables provided in storage 140 or through some other interface. Output may be provided to a user on a display device.

Figure **1b** schematically shows an example of an embodiment of a neural-network system 101 for estimating a plurality of random variables. System 101 is similar to system 100. System 101 comprises an input interface 151 and an output interface 152. The interfaces are as given above.

The input interface are used to receive observed data on which at least one or more of the random variable which are to be estimated depend. The output interface 152 is configured to output results of system 101, e.g., to a user, to a further device, to a further function, a further application, etc.

**Figure 1c** schematically shows a neural-network system 102 for estimating a plurality of random variables. System 102 is configured to a particular application. Shown in figure 1c is a sender 154. Sender 154 is configured to send one or more code words over a communication channel 155 to system 102. System 102 comprises a communication interface 153 for receiving the code word.

6

For example, sender 154 may be configured to encode information bits, which may each be mutually independent, into a codeword, which may comprise redundant information so that correlations exist among the bits of the codeword to allow for error correction at the receiver side, e.g., in system 102. At system 102, the observation of the codeword by interface 153 is noisy or corrupted by the communication channel. Belief propagation according to an embodiment may be used to recover the information bits based on the code bits correlation, e.g., parity checks in LDCP for instance and noisy observations. Preferably, interface 153 measures the received signal so that it can produce soft bits. For example, absence of a signal may correspond to a 0 and the strongest signal may correspond to a 1. A model of the channel may be used to convert the measured signal, to a probability that a 0 or 1 was sent. This probability needs to be refined by belief propagation, to take dependencies into account.

After belief propagation according to an embodiment, one could report the estimated probabilities for bits output interface 152; one could extract hard data bits from the error correct codeword, e.g., by rounding the probabilities, etc. The technique may be applied to any error correcting code, but is particularly useful for low density code words, such as LDPC codes.

**Figure 1d** schematically shows an example of an embodiment of a neural-network system 103 for estimating a plurality of random variables, that is not covered by the claims. System 103 is configured for a particular application.

Figured 1d shows a sensor system 171 comprising a plurality of sensors, and an actuator system 172. Sensor system 171 is configured for measuring sensors values from an environment surrounding sensor system 171. The environment is a physical environment in which physical object interact with each other. For example, the physical environment may be a traffic environment in which multiple traffic participants, e.g., pedestrians and/or vehicles, such as cars, bicycles, interact. The sensor measures physical properties of the objects in the environment, e.g., one or more of location, speed, and orientation. System 103 comprises sensor interface configured for receiving sensor data from the plurality of sensors.

Figure 1d shows an actuator system. Actuator system 172 is optional. For example, actuator system 172 may be configured to actuate an autonomous machine, e.g., an autonomous vehicle, in particular an autonomous car. Actuator system may comprise one or more of a motor, a brake and the like. System 103 comprises an actuator interface configured for controlling actuator system 172.

For example, system 103 may be configured estimate states of objects in the physical system. For example, the random variables may correspond to the true values of the physical properties, e.g., before being measured and subjected to noise. Moreover, some of the values may be temporarily invisible, e.g., due to obstruction. The random variables may comprise one or more historic values of the sensor values, so that the current values can be better estimated. Random values may also correspond to latent variables, e.g., an intent of the traffic participants, e.g., a destination, a likelihood of changing direction, etc.

After belief propagations according to an embodiment, an estimate of the random variables is obtained. System 103 may be configured to determine a control signal for actuator system 172. The control signal may be sent to system 172 over interface 158, e.g., wireless, wired, e.g., as an electronic signal, etc. The signal may be determined, e.g., to steer a vehicle, to avoid collision with other traffic participants, etc.

In the various embodiments of systems 100-103, the interfaces, such as communication interfaces may be selected from various alternatives. For example, the interface may be a network interface to a local or wide area network, e.g., the Internet, a storage interface to an internal or external data storage, a keyboard, an application interface (API), etc. An interface may be wired or wireless. An interface may be configured to forward an electronic signal configured to encode one or more of data, instructions and the like.

Systems 100-103 may have a user interface, which may include well-known elements such as one or more buttons, a keyboard, display, touch screen, etc. The user interface may be arranged for accommodating user interaction for configuring the systems, training the networks on a training set, or applying the system to sensor data, etc.

Storage 140 may be implemented as an electronic memory, say a flash memory, or magnetic memory, say hard disk or the like. Storage may comprise multiple discrete memories together making up storage 140. Storage may comprise a temporary memory, say a RAM. The storage may be cloud storage.

Systems 100-103 may be implemented in a single device. System 100-103 may be implemented in a single device. Typically, the systems 100-103 each comprise one or more microprocessors which executes appropriate software stored at the system; for example, that software may have been downloaded and/or stored in a corresponding memory, e.g., a volatile memory such as RAM or a non-volatile memory such as Flash. Alternatively, the systems may, in whole or in part, be implemented in programmable logic, e.g., as field-programmable gate array (FPGA). The systems may be implemented, in whole or in part, as a so-called application-specific integrated circuit (ASIC), e.g., an integrated circuit (IC) customized for their particular use. For example, the circuits may be implemented in CMOS, e.g., using a hardware description language such as Verilog, VHDL, etc. In particular, systems 100-103 may comprise circuits for the evaluation of neural networks.

Processor system 130 may comprise one or more processor circuits. A processor circuit may be implemented in a distributed fashion, e.g., as multiple sub-processor circuits. A storage may be distributed over multiple distributed sub-storages. Part or all of the memory may be an electronic memory, magnetic memory, etc. For example, the storage may have volatile and a non-volatile part. Part of the storage may be read-only.

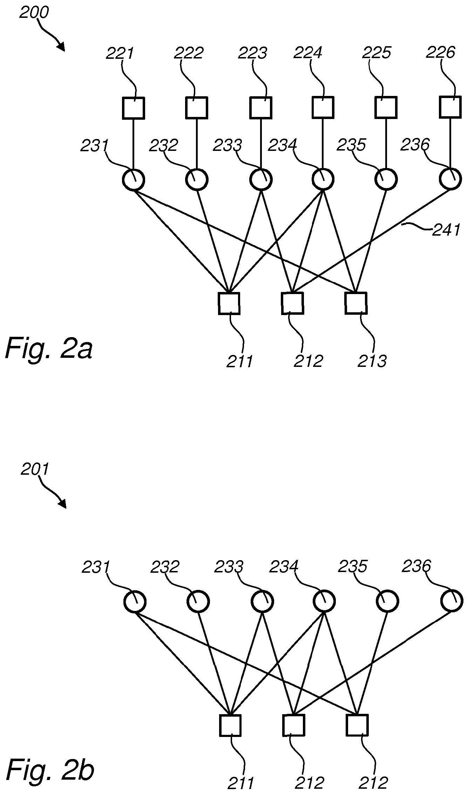

Storage 140 may be configured to store a representation of a graphical model. The graphical model representing a plurality of random variables and local decencies among them. Storage 140 may further comprise one or more neural networks, e.g., parameters of the neural networks. Processor system 130 is configured to iteratively perform belief propagation round for refining the belief-messages and neural network rounds to improve convergence of the belief propagation. Data on which the processor 130 acts may be stored in storage 140, e.g., including belief messages, received data, latent node data, estimated random variables, and the like. **Figure 2a** schematically shows a graphical model 200. The graph that is shown, is a so called factor graph which includes two types of nodes: variable nodes and factor nodes. Variable nodes are indicated in the figures as a small circle and correspond to a random variable. Factor nodes are indicated as a small square in the figures and correspond to dependencies among subsets of the random variables. The graph is bipartite: edges run between factor nodes and variable nodes. The presence of an edge indicates that a variable corresponding to one end of the edge is involved in the dependency on the other end of the edge. Graphic models can be represented in a storage, e.g., a computer memory in a variety of ways and need to be represented graphically as such.

As a motivating example, below the application of belief propagation for decoding of LDPC codes is considered. However, the belief propagation algorithms work similarly in other applications, that are not covered by the claims. One way to consider Belief Propagation is to regard joint probability distribution of all variables p(x). One is interested to know the estimate the marginal distribution for a particular random variable $X_i$. This is written as $p_{X_i}(x_i) = \sum_{x':x'_i=x_i} p(x')$.

Belief Propagation is a message passing algorithm that performs inference on graphical models exploiting the structure of the graph without need of marginalizing over all variables. A particular belief propagation algorithm is the sum-product algorithm. It is known belief propagation is an exact inference algorithm on tree factor graphs, but it is not guaranteed to converge or to provide the correct marginals in loopy graphs or in cases where the assumed distribution differs from the true one. The graph shown in figure 2a is cyclic.

A convenient way of representing graphical models is with factor graphs such as shown in figure 2a, where dependencies between variables are defined as factors. A factor graph factorizes a probability distribution as a product of factors $f_a(\mathbf{x}_a)$ wherein $\mathbf{x}_a$ is a subset of variables such that each factor contains one or more variables $X_i$: $p(\mathbf{x}) = \prod_{a \in F} f_a(\mathbf{x}_a)$ (1). $\mathbf{x}_a$ is the vector of neighboring variable nodes to the factor node a. The relation (1) may also be written as

$$p(\mathbf{x}) = \frac{1}{Z} \prod_{a \in F} f_a(\mathbf{x}_a)$$

, wherein Z is a normalization constant. The factors $f_a(\cdot)$ define relations between variables from the set $x_a$. Belief propagation directly operates on these factor graphs by sending messages from factors nodes to variables nodes and from variable nodes to factor nodes:

A plurality of belief-messages is defined for the edges between factor nodes and variable nodes for message passing between nodes of the graphical model in a belief propagation round. A belief-message from a factor a to a node v may be written as: $\mu_{a \to v}(x_v)$. A belief-message from a node v to a factor a is written as: $\mu_{v \to a}(x_v)$. Initially the belief messages may be uniformly, possibly including some variations, e.g., some randomness. However, the belief messages are iteratively refining by preforming multiple rounds of belief propagation (*BP*) comprising message passing the belief-messages among the nodes. The result of applying one round of belief propagation is denoted as $BP(\mu_{j \to i}^{(t)})$, in which the indices *i* and *j* run over all factor and variables nodes between which there is an edge. The index *t* indicates the round number.

Belief-messages are defined for edges in the graphical model between the variables nodes and the factor nodes. Updating a belief-message for an edge at a node comprises computing a new belief-message from at least the messages for other edges towards the node. It is convenient to differentiate between two types of message updating rules based on the type of nodes that the message departs from and arrives at. For example, for a message from a variable node to the factor node one may update a belief-message for an edge at a node by computing a new belief-message from at least the messages for other edges towards a node. For example, the variable node may multiply all its incoming messages except the one from the destination factor node. For a message from a factor node to a variable node, one may multiply the factor function with all incoming messages and marginalize over the involved variables except for the one associated to the destination variable node.

A belief message may be a real valued function, and is said to be passed along with the edges between the nodes. No actual movement need to take place, the message may simply be defined for their corresponding edges and iteratively updated. If *v* is a variable node and *a* is a factor node connected to v in the graph, then a message from *v* to a, $\mu_{v \to a}(x_v)$ may be a function whose domain is Dom(v), the set of values that can be taken by the random variable associated with v. For a binary code, the set of values of that can be taken to be 0 or 1. The belief messages thus transport information about the variable probabilities. The belief messages may be initialized with a uniform probability distribution. For discrete random variables or discretized random variables, the belief messages may be represented as vectors. In particular for a binary random variable, such as may occur during error correction, a belief message may be a two-dimensional real-valued vector.

For example, one may update a belief message from a variable node v to a factor node a, as $\forall x_v \in Dom(v), \mu_{v \to a}$

$(x_v) = \Pi_{a^* \in N(v) \backslash \{a\}} \, \mu_{a^* \to v}(x_v)$

In this equation, $N(v)$ is the set of neighboring nodes to $v$. If $N(v) \backslash \{a\}$ is empty, then $\mu_{v \to a}(x_v)$ is set to the uniform distribution. A message from a factor node $a$ to a variable node $v$ may be updated as: $\forall x_v \in Dom(v)$, $\mu_{a \to v}(x_v) = \Sigma_{x'_a : x'_v = x_v} f_a (x'_a) \Pi_{v^* \in N(a) \backslash \{v\}} \, \mu_{v^* \to a}(x'_{v^*})$.

These messages are propagated recursively through the factor graph by repeated rounds of belief propagation. After some iterations, usually after convergence, one obtains the estimate of a variable $X_v$ by multiplying all its incoming messages from its neighbor factors. We have:

$$p_{X_v}(x_v) \propto \prod_{a \in N(v)} \mu_{a \to v}(x_v)$$

The equation can be made exact using normalization, e.g., adding a normalization factor. Belief propagation for an appropriate graphic model is used to decode an error correcting code, in particular a linear code, to recover messages transmitted through noisy channels. For example, this technique is particularly useful for semi-random codes such as Low Density Parity Check codes which are linear codes. In a LDPC code, every code has a parity check sparse matrix **H**, where rows index over factors and columns index over variables. For a linear code $(n, k)$, $n$ represents the number of variables and $(n - k)$ the number of factors

Below, we show an example of an LDPC code with $n = 6$, $k = 3$, and parity check matrix:

$$\mathbf{H} = \begin{pmatrix} 1 & 1 & 1 & 1 & 0 & 0 \\ 0 & 0 & 1 & 1 & 0 & 1 \\ 1 & 0 & 0 & 1 & 1 & 0 \end{pmatrix}$$

Before transmission, a code-word x is created such that **Hx = 0**. Therefore, the prior probability of a transmitted codeword can be defined as: $P(\mathbf{x}) \propto 1[\mathbf{Hx = 0}]$. And the posterior probability of a received codeword after transmitting it through the noisy channel may be defined as: $P(\mathbf{x}|\mathbf{r}) \propto P(\mathbf{x})P(\mathbf{r}|\mathbf{x})$. In this equation $r$ represents the code word as received. The latter equation can be regarded as a factorization of the probability distribution, e.g., as in equation (1) above. The factor $P(\mathbf{x})$ further factorizes into three factors that correspond to the parity checks defined by H. For example, you might define the first factor as $f_1(x_1, x_2, x_3, x_4)$ which is

1 if $x_1 + x_2 + x_3 + x_4 = 0$ and
0 if $x_1 + x_2 + x_3 + x_4 = 1$ (m$od$ 2)

The factor $P(\mathbf{r}|\mathbf{x})$ further factorizes into six factors. They are $P(r_1|x_1), \dots , P(r_6|x_6)$. These factors can be computed by modelling the physical channel. For example, we may set

$$P(r_n|x_n) \propto \exp\left(-\frac{(r_n - x_n)^2}{N_0}\right),$$

as one particular way to model the physical communication channel. The factor $N_0$ represents the noise variance on the channel. The resulting graphic model is shown in figure 2a. The factors 221-226 represent the factors $P(r_6|x_6)$. Together they represent the noisy channel. The variable nodes 231-236 represent the bits of the code word as transmitted. The factors 211-213 as the bottom represent the parity checks in the code word. Figure 2a is a visual representation as a factor graph of the above mentioned matrix H where variables and factors are interconnected.

In order to infer the transmitted code-word x given the received code-word r, one could just run Belief Propagation on the above defined Factor Graph. It can be seen that the messages passed on the edges between factors 221-226 and variable nodes 231-236 are constant as they only depend on the code word as received. For this reason, the factor graph 200 may be simplified to the graph 201 shown in **figure 2b.** The belief messages that are passed for graph 201 may be adapted to compensate for having fewer factors. That is the particular received noisy code word may be reflected in coefficients of the belief propagation rounds.

One may define $\mu^x_{m \to n}$ the message that goes from parity check factor m to a variable $n$. And $\mu^x_{n \to m}$ is meant to be the message that goes from a variable $n$ to a parity check factor m. For example, one may call $p^x_n$ the prior probability of a bit $x_n$. For example, $p^1_n$ may be the prior probability of $x_n$ being 1 and $p^0_n$ the prior probability of it being 0. This value $p^x_n$ is defined by the singleton factor $p(r_n|x_n)$. Now given this notation, if we run belief propagation on the factor graph from figure 2b one may obtain the following equations:

Factor to variable

$$\mu_{m \to n}^{x} = \sum_{\{x_{n'}: n' \in \mathcal{N}(m) \backslash n\}} P(x_n = x, \{x_{n'}: n' \in \mathcal{N}(m) \backslash n\}) \prod_{n' \in \mathcal{N}(m) \backslash n} \mu_{n' \to m}^{x_{n'}} \qquad (8)$$

The equation $P(x_n = x, \{x_{n'}: n' \in \mathcal{N}(m) \backslash n\})$ may represent the factor $f_m$.

**Variable to factor**

$$\hat{p}(x_n = x) = \alpha_n p_n^x \prod_{m \in \mathcal{M}(n)} \mu_{m \to n}^x \qquad (10)$$

Where $\alpha_{mn}$ is a normalization factor, which is optional. The values $p_n^x$ correspond to the omitted factors 221-226. Technically they are also a belief message, but it is preferably written like this since its value does not change during the BP algorithm, while the others do.

**Variable estimate**

$$\mu_{n \to m}^{x} = \alpha_{mn} p_n^x \prod_{m' \in \mathcal{M}(n) \backslash m} \mu_{m' \to n}^x \qquad (9)$$

Below neural networks rounds are combined with belief propagation rounds as described above. Belief messages are defined and passed, as defined above. However, between some rounds they are adapted, e.g., a correction is applied, to improve their convergence. After a belief propagation round, e.g., after each BP round, one inputs the belief messages into one or more neural networks. The neural network(s) operate for one or more iterations and update for the Belief Propagation messages. These rounds of belief propagation and neural networks step are repeated, e.g., a fixed amount of iterations, or until convergence, after which, the marginals are computed from belief messages.

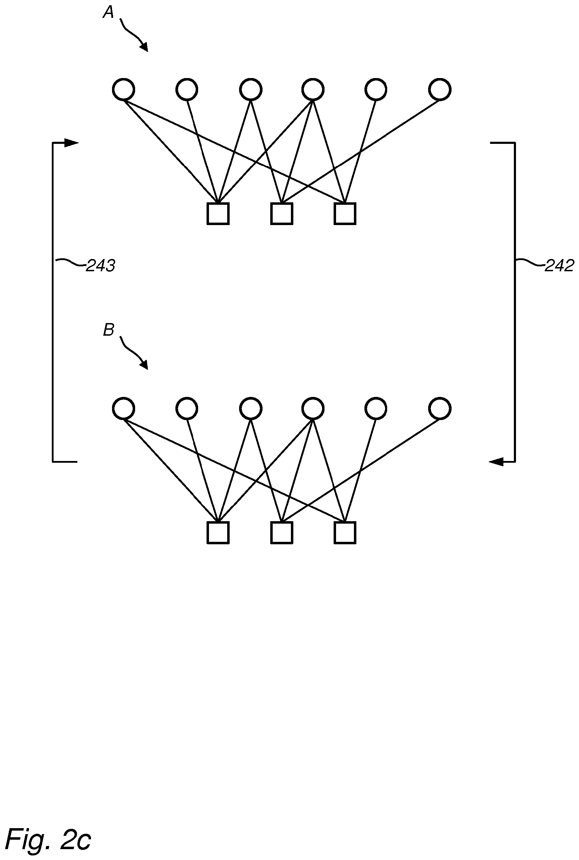

The present invention makes the particularly suitable choice for the neural networks of a so-called graph neural network (GNN). A graph neural network includes in its definition a graph, which determines how the neural network outputs are computed. Figure 2c illustrates a graphic model A, like the graphic model 201 of figure 2b. Belief messages are defined for graphic model A. In principle one repeatedly updates the belief messages in a graphic model A, until convergence. Also shown in figure 2b is a graph neural network B. Graph neural network B comprises a graph, which is taken as the same graph as the graphic model A. The nodes of the GNN B correspond to nodes of the graphic model A. Each node of the graphic model corresponds to particular set of nodes of the GNN B. Typically the two nodes of the graphic model correspond to different nodes or set of nodes in the GNN. In an embodiment, the two graphs may be isomorphic, e.g., the same.

However, instead of belief messages, the GNN B may have its own data structures to reason about random variables. For example, in an embodiment, latent node data $h_i$ may be defined for the multiple nodes of the GNN. In an implementation, one could take the same graph representation, and store belief messages associated with its edges and latent node data with its node. The latent node data is persistent like the belief messages, in the sense that it is kept beyond a round. This data is updated in a new round, not initialized again.

Other data structures are possible, for example, the GNN may persistently keep latent edge data, which is updated from neural network round to neural network round, e.g., in addition or instead of the latent node data. Accordingly, after repeated neural network rounds, beliefs about the true values of the random variables is spread through the GNN not unsimilar to the belief messages. Nevertheless, the messages may behave quite differently. For example, the graphic model A may have a high bias, while the GNN B may have a high variance, e.g., as associated with the underlying neural networks of the GNN. Moreover, a belief propagation round does not have the ability to learn new properties of the system that are not represented in its factor functions, e.g., additional properties such as additional dependencies of the communication channel, environment, sensors and the like.

After one or more rounds of belief propagation the system switches 242 to GNN B. After one or more neural network rounds, the system switches back to 243. In the GNN B, the latent data, e.g., the latent node data is updated based upon the output the BP round, while in the following BP round the belief messages are updated based on the output of the GNN round.

In order to simplify the notation, from now on we call $\mu_{j\to i}^{(t)}$ to any message from the subset of messages $\{\mu_{f_s\to x_n}(x_n), \mu_{x_m\to f_s}(x_m)\}$, that goes from a node $j$ to a node $i$, regardless whether they go from variable to factor or from factor to variable. The index $t$ defines the iteration step. Following this simplified notation, we define a belief propagation update:

$$\mu_{j\to i}^{(t)\prime} = BP(\mu_{j\to i}^{(t)}) \qquad\qquad (11)$$

Where messages $\mu_{j\to i}^{(0)}$ in the first iteration $t = 0$ may be initialized with a uniform probability distribution. The following neural network round is defined as: $\mu_{j\to i}^{(t+1)} = NN(\mu_{j\to i}^{(t)\prime})$. Note that this notation assumes that the BP and NN rounds are alternating. Note that a BP or an NN update uses multiple inputs, e.g., multiple belief messages, and latent data to update a belief message, not just the previous value of a belief message.

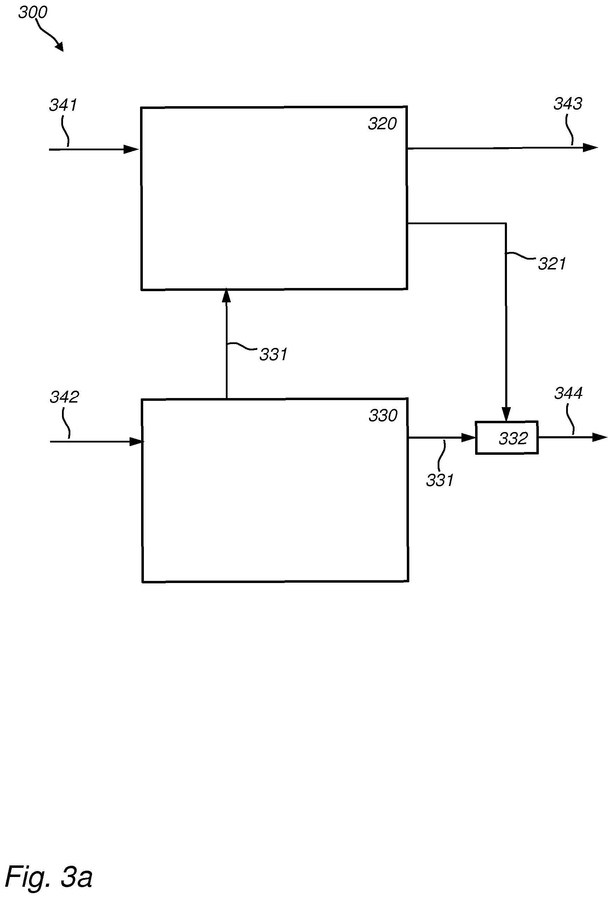

A neural network round, i.e. a GNN message-passing operation operates on the GNN graph, which is taken as the same graph as the factor graph. That is the BP graph A and GNN graph B are the same graph. However, in the GNN graph, each node is initialized with a latent data vector $\mathbf{h}_i$. The latent data vector may be randomly initialized. Next one may define neural networks that update the latent data, preferably as a function of latent data on nodes in the neighborhood and as a function of belief messages on edges in the neighborhood. Finally, a neural network may learn a function that maps the latent data to a correction factor for the belief messages. Shown in figure 3a is a neural network function 320 comprising one or more neural networks, and a BP function 330. BP function 330 receives as input the belief messages 342 as computed in a previous round. The BP function performs message passing according to a known belief propagation round, such as sum-product message passing. The refined belief messages 331 are provided as an input to NN function 320. NN function also receives latent data 341 as input, e.g., latent node data. The NN function produces as output, updated latent node data 343 and correction data, or adaption data 321. Correction data 321 is provided to a correction function 332 together with the belief messages 331, where the correction is applied. For example, the correction terms 321 may be added to the belief messages 331.

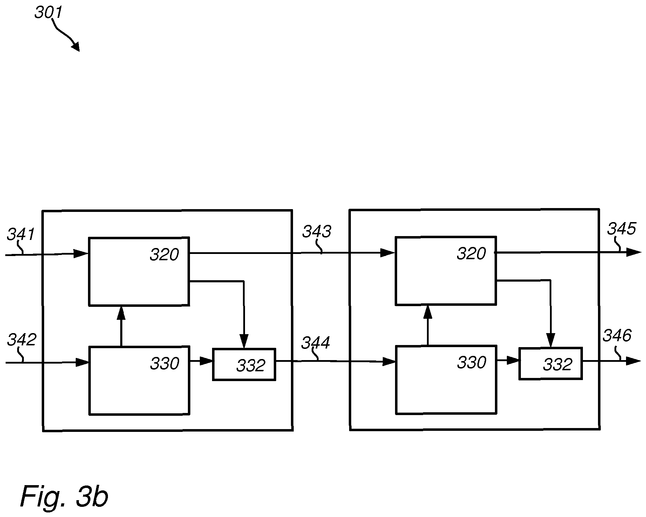

BP rounds and NN rounds are alternated as shown in **figure 3b.** At the left latent data 341 and belief messages 342 are updated after one BP round and NN round into latent data 343 and belief messages 344 which are then updated in a next BP round and NN round in to latent data 345 and belief messages 346.

For example, one may make the following choices for the neural networks in the neural network function 320:

$$
\begin{aligned}
\mathbf{e}_{j\to i}^{(t)} &= \sum_k z_{i,j,k}\phi_k\left(\mathbf{h}_i^{(t)}, \mathbf{h}_j^{(t)}, \mu_{j\to i}^{(t)\prime}\right) &&\text{node to edge}\\
\mathbf{e}_i^{(t)} &= \sum_{j\in\mathcal{N}(i)} \mathbf{e}_{j\to i}^{(t)} &&\text{edge to node}\\
\mathbf{h}_i^{(t+1)} &= \rho_l\left(\mathbf{e}_i^{(t)}, \mathbf{h}_i^{(t)}\right) &&\text{edge to node}\\
\mu_{j\to i}^{(t+1)} &= \mu_{j\to i}^{(t)\prime} + f_{dec}(\mathbf{e}_{j\to i}^{(t)}) &&\text{BP update}
\end{aligned}
\qquad (12)
$$

The values $\mathbf{e}_{j\to i}^{(t)}$ and $\mathbf{e}_i^{(t)}$ are intermediate data, which are computed again for a next round, while the values $\mathbf{h}_i^{(t)}$ are persistent in the sense that after updating them they are used in a next round as well.

The functions $\phi_k$ may be called the GNN edge operation, the subindex $k$ describes the type of edge, which may depend on the factors of the graphical model. The functions $\phi_k$ may be neural networks. For example one may use a different function $\phi_k$ if the message goes from a variable $j$ to a factor $i$ than from a factor $j$ to a variable $i$.

A different function may be used for different types of edges, e.g., connecting to different types of factors. This allows the GNN model to incorporate information about the system which is difficult to incorporate in a belief graph. In an example that is not covered by the claims, different edges may correspond to different types of traffic participants, e.g., a different network may model pedestrians than cars. Typically, the values $z_{i,j,k}$ are 0 or 1, moreover one would typically use

$\Sigma_k z_{i,j,k} = 1$; this not necessary though. In an embodiment, one could use a single network instead of multiple functions $\phi_k$. The functions $\phi_k$ may be neural networks, e.g., MLPs.

The function $\rho_l(\cdot)$ combines the aggregated messages $\mathbf{e}_i^{(t)}$ of a node $i$ with the current representation $\mathbf{h}_i^{(t)}$ of that node. The function $\rho_l(\cdot)$ may be a neural network. For example, in an embodiment one may use a Gated Recurrent Unit for this function but other functions can be used. Different weights may be used for $\rho_l(\cdot)$ depending on the type of node.

Finally, the belief message $\mu_{j \to i}^{(t)\prime}$ is updated from the learned GNN message $f_{dec}(\mathbf{e}_{j \to i}^{(t)})$ where $f_{dec}(\cdot)$ is an MLP.

After a number of iterations one can estimate the marginal of a variable $X_v$ by multiplying all its incoming belief messages.

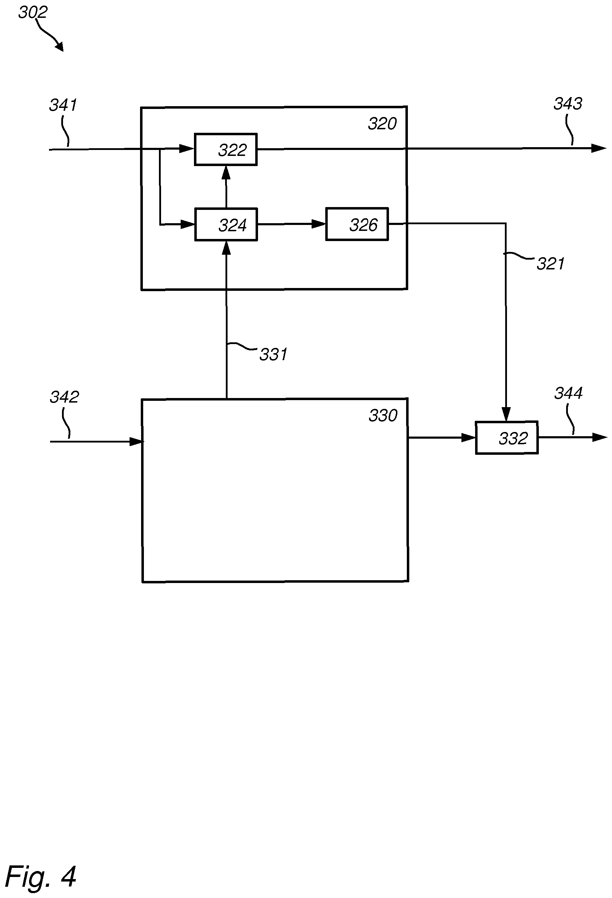

An example of an NN function for the NN round is shown in **figure 4.** Shown in figure 4 is a node to edge function 324, e.g., function(s) $\phi_k$, an edge to node function 322, e.g., function $\rho_l$ (e.g., incorporating the summation shown above) and an edge to belief function 326, e.g., function $f_{dec}$.

To train the neural networks, one may define a loss function which may be computed from the estimated marginals $\hat{p}(x)$ and ground truth. During training one may back-propagate updating the GNN weights. The number of training iterations may be chosen by cross-validating, e.g., $Loss(\Theta) = \mathcal{L}(gt, \hat{p}(x))$. Training may be done using a system such as Adam.

In which $\Theta$ stands for the set of all learnable parameters. The loss function may comprise cross entropy or mean square difference, etc. between ground truth and the estimated random variables.

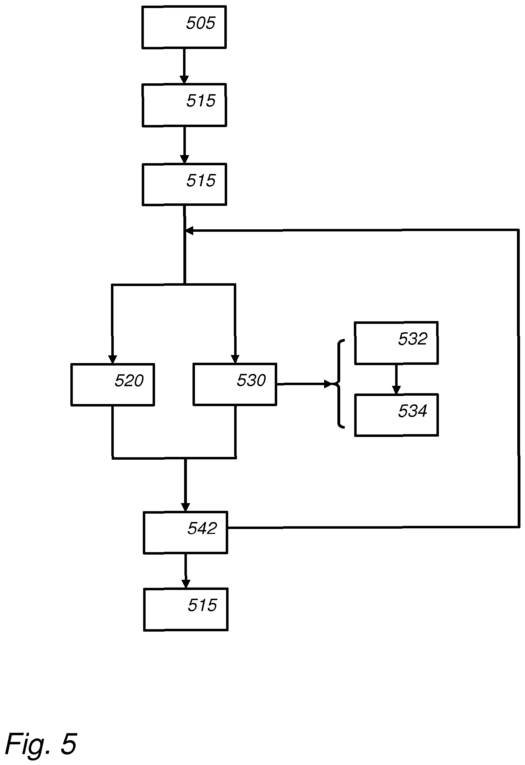

**Figure 5** schematically shows a method 500 for estimating a plurality of random variables. Method 500 is computer implemented. The random variables and local dependencies among the random variables being represented in a graphical model, the graphical model comprising a plurality of variable-nodes corresponding to the plurality of random variables and a plurality of factor-nodes corresponding to the local dependencies. Method 500 comprises

- receiving 505 a noisy codeword over a communication channel from a sender, a codeword as transmitted by the sender over the communication channel being represented by the plurality of random variables, parity conditions in the codeword as transmitted being represented by local dependencies, belief propagation being in accordance with the noisy codeword as received,
- defining 510 a plurality of belief-messages ($\mu_{a \to v}(x_v)$, $\mu_{v \to a}(x_v)$) for message passing between nodes of the graphical model in a belief propagation round,
- defining 515 latent node data ($h_i$) for the multiple nodes, a neural network round comprising
- iteratively refining the belief-messages by preforming 520 multiple rounds of belief propagation (*BP*) comprising message passing the belief-messages among the nodes $(\mu_{j \to i}^{(t)\prime} = BP(\mu_{j \to i}^{(t)}))$, the method further comprising

  - performing 530 multiple neural network rounds between the rounds of belief propagation $(\mu_{j \to i}^{(t+1)} = NN(\mu_{j \to i}^{(t)\prime}))$, the belief-messages being adapted in the neural network rounds according to one or more neural networks trained to improve convergence of the belief propagation,

A neural network round may comprise

- updating 532 the latent node data for a node according to one or more neural networks from at least one or more of: a belief-message defined for that node, e.g., the belief message sent towards that node, latent node data for that node, latent node data defined for surrounding nodes,
- adapting 534 a belief-message from at least one or more of: latent node data for a node corresponding to the belief-message, a previous value of the belief-message.

The method may further comprise, deciding 542 whether a further round is needed, e.g., by counting the number of performed rounds and comparing to a threshold, or by monitoring convergence. A fixed number of rounds is particularly useful for training, while monitoring convergence is better suited for practical use, possibly coupled with a number of rounds upper bound. The rounds 520 and 530 may alternate or follow some other schedule, e.g., two rounds of one for every one round of the other, etc. Note that and embodiment according to the hybrid method cannot necessarily guarantee convergence, although empirically a better convergence rate was shown. Indeed, the hybrid method is unlikely to do worse than native BP, since an NN round could learn to modify the belief messages only little or not at all. For difficult cases, the NN rounds improve convergence, e.g., because a better approximation of the communication channel is learned that is available in the BP rounds, e.g., because a correction can be applied when divergence is looming.

Finally, the estimates are computed, e.g., as

- computing 540 an estimate $(p_{X_v}(x_v) \propto \Pi_{a \in N(v)} \mu_{a \to v}(x_v))$ for a random variable $(X_v)$ from belief-messages passed to the node (v) representing the random variable.

Several variants are possible for method 500. In an example not covered by the claims, the method may be applied to other random variables than received code bits. Latent data may be different from latent node data, etc. Computing an estimate 540 for a random variable may comprise computing the probabilities of its different values. If the random variables are binary, the probability may be rounded to go from a soft bit to a hard bit. Generally, one estimates the distribution of the random variables. Depending on the downstream applications, one can derive different statistical properties on top of the distribution estimate. For instance, hard decision on the most likely bit value, or estimate the mean square error, etc.

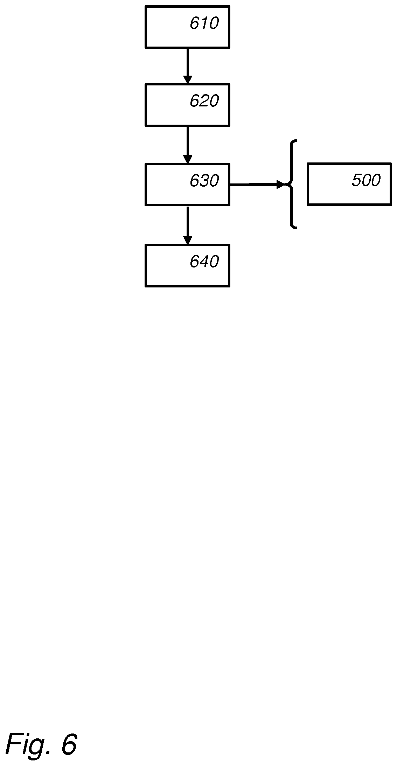

**Figure 6** schematically shows an example of an embodiment of a method 600 for training one or more neural networks. Method 600 may be computer implemented. Method 600 comprises

- obtaining 610 training data comprising ground truth data for the random variables and observed data for the belief propagation,
- obtaining 620 trainable parameters for one or more neural networks as in claim 1,
- performing 630 the method according to claim 1 with one or more neural networks according to the trainable parameters,
- performing 640 a neural network training algorithm to train the trainable parameters according to the training data.

The neural networks which are used in method 600 are at first badly trained, and gradually their training improves.

The neural network methods are computer implemented methods. For example, accessing training data, and/or receiving input data may be done using a communication interface, e.g., an electronic interface, a network interface, a memory interface, etc. For example, storing or retrieving parameters may be done from an electronic storage, e.g., a memory, a hard drive, etc., e.g., parameters of the networks. For example, applying a neural network to data of the training data, and/or adjusting the stored parameters to train the network may be done using an electronic computing device, e.g., a computer. The encoder and decoder can also output mean and/or variance, instead of directly the output. In case of mean and variance to obtain the output one has to sample from this defined Gaussian.

The neural networks, either during training and/or during applying may have multiple layers, which may include, e.g., convolutional layers and the like. For example, a neural network may have at least 2, 5, 10, 15, 20 or 40 hidden layers, or more, etc. The number of neurons in the neural network may, e.g., be at least 10, 100, 1000, 10000, 100000, 1000000, or more, etc.

Many different ways of executing the method are possible, as will be apparent to a person skilled in the art. For example, the order of the steps can be performed in the shown order, but some steps may be executed in parallel. Moreover, in between steps other method steps may be inserted. The inserted steps may represent refinements of the method such as described herein. For example, some steps may be executed, at least partially, in parallel. Moreover, a given step may not have finished completely before a next step is started.

The method is executed using software, which comprises instructions for causing a processor system to perform method 500 or 600. The software may be stored in a suitable storage medium, such as a hard disk, a floppy, a memory, an optical disc, etc. The software may be sent as a signal along a wire, or wireless, or using a data network, e.g., the Internet. The software may be made available for download and/or for remote usage on a server. Embodiments of the method may be executed using a bitstream arranged to configure programmable logic, e.g., a field-programmable gate array (FPGA), to perform the method.

It will be appreciated that the presently disclosed subject matter also extends to computer programs, particularly computer programs on or in a carrier, adapted for putting the presently disclosed subject matter into practice. The program may be in the form of source code, object code, a code intermediate source, and object code such as partially compiled form, or in any other form suitable for use in the implementation of an embodiment of the method. An embodiment relating to a computer program product comprises computer executable instructions corresponding to each of the processing steps of at least one of the methods set forth. These instructions may be subdivided into subroutines and/or be stored in one or more files that may be linked statically or dynamically. Another embodiment relating to a computer program product comprises computer executable instructions corresponding to each of the devices, units and/or parts of at least one of the systems and/or products set forth.

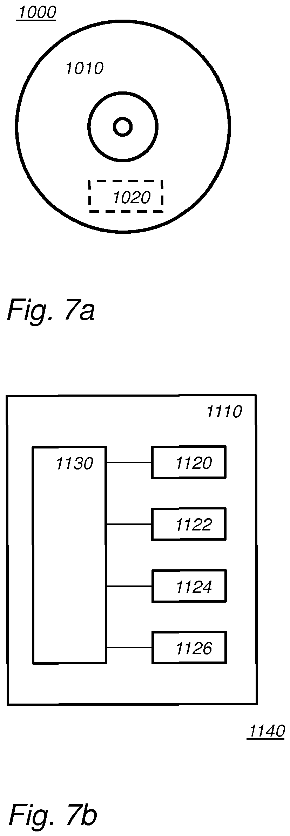

**Figure 7a** shows a computer readable medium 1000 having a writable part 1010 comprising a computer program 1020, the computer program 1020 comprising instructions for causing a processor system to perform a neural network method or neural network training method, according to an embodiment. The computer program 1020 is embodied on the computer readable medium 1000 as physical marks or by magnetization of the computer readable medium 1000. Furthermore, it will be appreciated that, although the computer readable medium 1000 is shown here as an optical disc, the computer readable medium 1000 may be any suitable computer readable medium, such as a hard disk, solid state memory, flash memory, etc., and may be non-recordable or recordable. The computer program 1020 comprises instructions for causing a processor system to perform said method of neural network method or neural network training method.

**Figure 7b** shows in a schematic representation of a processor system 1140 according to an embodiment of a neural network system. The processor system comprises one or more integrated circuits 1110. The architecture of the one or more integrated circuits 1110 is schematically shown in Figure 7b. Circuit 1110 comprises a processing unit 1120, e.g., a CPU, for running computer program components to execute a method according to an embodiment and/or implement its modules or units. Circuit 1110 comprises a memory 1122 for storing programming code, data, etc. Part of memory 1122 may be read-only. Circuit 1110 may comprise a communication element 1126, e.g., an antenna, connectors or both, and the like. Circuit 1110 may comprise a dedicated integrated circuit 1124 for performing part or all of the processing defined in the method. Processor 1120, memory 1122, dedicated IC 1124 and communication element 1126 may be connected to each other via an interconnect 1130, say a bus. The processor system 1110 may be arranged for contact and/or contact-less communication, using an antenna and/or connectors, respectively.

For example, in an embodiment, processor system 1140, e.g., a neural network system or neural network device may comprise a processor circuit and a memory circuit, the processor being arranged to execute software stored in the memory circuit. For example, the processor circuit may be an Intel Core i7 processor, ARM Cortex-R8, etc. In an embodiment, the processor circuit may be ARM Cortex M0. The memory circuit may be an ROM circuit, or a non-volatile memory, e.g., a flash memory. The memory circuit may be a volatile memory, e.g., an SRAM memory. In the latter case, the device may comprise a non-volatile software interface, e.g., a hard drive, a network interface, etc., arranged for providing the software.

While device 1100 is shown as including one of each described component, the various components may be duplicated in various embodiments. For example, the processor 1120 may include multiple microprocessors that are configured to independently execute the methods described herein or are configured to perform steps or subroutines of the methods described herein such that the multiple processors cooperate to achieve the functionality described herein. Further, where the device 1100 is implemented in a cloud computing system, the various hardware components may belong to separate physical systems. For example, the processor 1120 may include a first processor in a first server and a second processor in a second server.

It should be noted that the above-mentioned embodiments illustrate rather than limit the presently disclosed subject matter, and that those skilled in the art will be able to design many alternative embodiments. Use of the verb 'comprise' and its conjugations does not exclude the presence of elements or steps other than those stated in a claim. The article 'a' or 'an' preceding an element does not exclude the presence of a plurality of such elements. Expressions such as "at least one of" when preceding a list of elements represent a selection of all or of any subset of elements from the list. For example, the expression, "at least one of A, B, and C" should be understood as including only A, only B, only C, both A and B, both A and C, both B and C, or all of A, B, and C. The presently disclosed subject matter may be implemented by hardware comprising several distinct elements, and by a suitably programmed computer. In the device claim enumerating several parts, several of these parts may be embodied by one and the same item of hardware.

In the claims references in parentheses refer to reference signs in drawings of exemplifying embodiments or to formulas of embodiments, thus increasing the intelligibility of the claim. These references shall not be construed as limiting the claim.

**Claims**

1.    A computer-implemented method (500) for estimating a plurality of random variables $(X_i)$, the random variables and local dependencies among the random variables being represented in a graphical model, the graphical model comprising a plurality of variable-nodes corresponding to the plurality of random variables and a plurality of factor-nodes corresponding to the local dependencies, the method comprising

- receiving (505) a noisy codeword over a communication channel from a sender, a codeword as transmitted by the sender over the communication channel being represented by the plurality of random variables, parity conditions in the codeword as transmitted being represented by the local dependencies,
- defining (510) a plurality of belief-messages $(\mu_{a\to v}(x_v), \mu_{v\text{-}a\text{-}}(x_v))$ for message passing between the nodes of the graphical model in a belief propagation round,
- iteratively refining the belief-messages by performing (520) multiple rounds of belief propagation (*BP*) comprising message passing the belief-messages among the nodes $\left(\mu_{j\to i}^{(t)\prime} = BP(\mu_{j\to i}^{(t)})\right)$, wherein the belief propagation rounds are in accordance with the noisy codeword as received,
- performing (530) multiple neural network rounds between the rounds of belief propagation

$$\left(\mu_{j\rightarrow i}^{(t+1)} = NN\left(\mu_{j\rightarrow i}^{(t)\prime}\right)\right)$$ such that belief propagation rounds are alternated with neural network rounds, wherein each neural network round is adapting the belief-messages according to a graph neural network (GNN), wherein nodes of the graph neural network correspond to the nodes of the graphical model,
- computing (540) an estimate ($px_v(x_v) \propto \Pi_{a \in N(v)} \mu_{a \rightarrow v}(x_v)$) for each random variable ($X_v$) from the belief-messages passed to the node ($v$) representing the random variable, and using the computed estimates to decode the noisy codeword as received into the codeword as transmitted.

2. The method according to claim 1, comprising

- defining (515) latent node data ($h_i$) for the multiple nodes, a neural network round comprising
- updating (532) the latent node data for a node according to one or more neural networks from at least one or more of: a belief-message defined for that node, latent node data for that node, latent node data defined for surrounding nodes,
- adapting (534) a belief-message from at least one or more of: latent node data for a node corresponding to the belief-message, a previous value of the belief-message.

3. The method according to claim 2, wherein the latent node data is initiated randomly.

4. A computer-implemented method (600) for training one or more neural networks, the training method comprising the method of claim 1 and further comprising

- obtaining (610) training data comprising ground truth data for the random variables and observed data for the belief propagation,
- obtaining (620) values of trainable parameters for the one or more neural networks,
- performing (630) the method according to claim 1 with the one or more neural networks according to the values of the trainable parameters,
- performing (640) a neural network training algorithm to train the trainable parameters according to the training data.

5. A neural-network system for estimating a plurality of random variables, the system comprising

- a neural network storage configured to store parameters of one or more neural networks,
- a model storage configured to store a representation of a graphical model having multiple nodes, the multiple nodes including a plurality of variable-nodes corresponding to the plurality of random variables and a plurality of factor-nodes corresponding to local dependencies between the random variables,
- a communication interface configured for receiving a noisy codeword over a communication channel from a sender, a codeword as transmitted by the sender over the communication channel being represented by the plurality of random variables, parity conditions in the codeword as transmitted being represented by the local dependencies,
- a processor system configured for
- defining a plurality of belief-messages for message passing between the nodes of the graphical model in a belief propagation round,
- iteratively refining the belief-messages by performing multiple rounds of belief propagation comprising message passing the belief-messages among the nodes, wherein the belief propagation rounds are in accordance with the noisy codeword as received,
- performing multiple neural network rounds between the rounds of belief propagation such that belief propagation rounds are alternated with neural network rounds, wherein each neural network round is adapting the belief-messages according to a graph neural network (GNN), wherein nodes of the graph neural network correspond to the nodes of the graphical model,
- computing an estimate for each random variable from the belief-messages passed to the node representing the random variable, and using the computed estimates to decode the noisy codeword as received into the codeword as transmitted.

6. The neural-network system of claim 5, wherein the processor system is further configured for

- obtaining training data comprising ground truth data for the random variables and observed data for the belief propagation,
- obtaining values of trainable parameters for the one or more neural networks
- performing the method according to claim 1 with the one or more neural networks according to the values of the trainable parameters,
- performing a neural network training algorithm to train the trainable parameters according to the training data.

7. A transitory or non-transitory computer readable medium (1000) comprising instructions, which when executed by a processor system, cause the processor system to perform the method according to any one of claims 1 to 4.

## Patentansprüche

1. Computerimplementiertes Verfahren (500) zum Schätzen einer Vielzahl von Zufallsvariablen ($X_i$), wobei die Zufallsvariablen und lokalen Abhängigkeiten unter den Zufallsvariablen in einem grafischen Modell dargestellt sind, wobei das grafische Modell eine Vielzahl von Variablenknoten, die der Vielzahl von Zufallsvariablen entsprechen, und eine Vielzahl von Faktorknoten, die den lokalen Abhängigkeiten entsprechen, umfasst, wobei das Verfahren Folgendes umfasst:

- Empfangen (505) eines verrauschten Codeworts über einen Kommunikationskanal von einem Sender, wobei ein Codewort, wie es durch den Sender über den Kommunikationskanal übertragen wird, durch die Vielzahl von Zufallsvariablen repräsentiert wird, wobei Paritätsbedingungen in dem Codewort, wie es übertragen wird, durch die lokalen Abhängigkeiten repräsentiert werden,
- Definieren (510) einer Vielzahl von Glaubensnachrichten ($\mu_{a \to v}(x_v)$, $\mu_{v \to a}(x_v)$) für Nachrichtenübermittlung zwischen den Knoten des grafischen Modells in einer Glaubensverbreitungsrunde,
- iteratives Verfeinern der Glaubensnachrichten durch Durchführen (520) mehrerer Runden der Glaubensverbreitung (*BP*) umfassend Nachrichten, die die Glaubensnachrichten unter den Knoten weiterleiten, $\left(\mu_{j \to i}^{(t)\prime} = BP(\mu_{j \to i}^{(t)})\right)$

wobei die Glaubensverbreitungsrunden im Einklang mit dem verrauschten Codewort, wie empfangen, wie folgt sind:

- Durchführen (530) mehrerer neuronaler Netzwerkrunden zwischen den Runden der Glaubensverbreitung $\left(\mu_{j \to i}^{(t+1)} = NN(\mu_{j \to i}^{(t)\prime})\right)$, so dass Glaubensverbreitungsrunden mit neuronalen Netzwerkrunden alterniert werden, wobei jede neuronale Netzwerkrunde die Glaubensnachrichten gemäß einem neuronalen Graphennetzwerk (GNN) anpasst, wobei Knoten des neuronalen Graphennetzwerks den Knoten des grafischen Modells entsprechen,
- Berechnen (540) einer Schätzung ($px_v(x_v) \propto \Pi_{a \in N(v)} \mu_{a \to v}(x_v)$) für jede Zufallsvariable ($X_v$) aus den Glaubensnachrichten, die an den Knoten (*v*) weitergeleitet werden, der die Zufallsvariable repräsentiert, und Verwenden der berechneten Schätzungen zum Decodieren des verrauschten Codeworts, wie empfangen, in das Codewort, wie es übertragen wird.

2. Verfahren nach Anspruch 1, das Folgendes umfasst:

- Definieren (515) latenter Knotendaten ($h_i$) für die mehreren Knoten, wobei eine neuronale Netzwerkrunde Folgendes umfasst:

- Aktualisieren (532) der latenten Knotendaten für einen Knoten gemäß einem oder mehreren neuronalen Netzwerken von mindestens einem oder mehreren von: einer Glaubensnachricht, die für diesen Knoten definiert ist, latenten Knotendaten für diesen Knoten, latenten Knotendaten, die für umgebende Knoten definiert sind,
- Anpassen (534) einer Glaubensnachricht von mindestens einem oder mehreren von: latenten Knotendaten für einen Knoten, der der Glaubensnachricht entspricht, einem vorherigen Wert der Glaubensnachricht.

3. Verfahren nach Anspruch 2, wobei die latenten Knotendaten zufällig initiiert werden.

4. Computerimplementiertes Verfahren (600) zum Trainieren eines oder mehrerer neuronaler Netzwerke, wobei das

**EP 3 792 832 B1**

Trainingsverfahren das Verfahren nach Anspruch 1 umfasst und ferner Folgendes umfasst:

- Erhalten (610) von Trainingsdaten, die Grundwahrheitsdaten für die Zufallsvariablen und beobachtete Daten für die Glaubensverbreitung umfassen,
- Erhalten (620) von Werten trainierbarer Parameter für das eine oder die mehreren neuronalen Netzwerke,
- Durchführen (630) des Verfahrens nach Anspruch 1 mit dem einen oder den mehreren neuronalen Netzwerken gemäß den Werten der trainierbaren Parameter,
- Durchführen (640) eines neuronalen Netzwerktrainingsalgorithmus, um die trainierbaren Parameter gemäß den Trainingsdaten zu trainieren.

5. Neuronales Netzwerksystem zum Schätzen einer Vielzahl von Zufallsvariablen, wobei das System Folgendes umfasst:

- einen Speicher eines neuronalen Netzwerks, der dazu ausgebildet ist, Parameter eines oder mehrerer neuronaler Netzwerke zu speichern,
- einen Modellspeicher, der dazu ausgebildet ist, eine Repräsentation eines grafischen Modells mit mehreren Knoten zu speichern, wobei die mehreren Knoten eine Vielzahl von Variablenknoten, die der Vielzahl von Zufallsvariablen entsprechen, und eine Vielzahl von Faktorknoten, die lokalen Abhängigkeiten zwischen den Zufallsvariablen entsprechen, beinhalten,
- eine Kommunikationsschnittstelle, die zum Empfangen eines verrauschten Codeworts über einen Kommunikationskanal von einem Sender konfiguriert ist, wobei ein Codewort, wie es durch den Sender über den Kommunikationskanal übertragen wird, durch die Vielzahl von Zufallsvariablen repräsentiert wird, wobei Paritätsbedingungen in dem Codewort, wie es übertragen wird, durch die lokalen Abhängigkeiten repräsentiert werden,
- ein Prozessorsystem, das für Folgendes ausgebildet ist:

- Definieren einer Vielzahl von Glaubensnachrichten für Nachrichtenübermittlung zwischen den Knoten des grafischen Modells in einer Glaubensverbreitungsrunde,
- iteratives Verfeinern der Glaubensnachrichten durch Durchführen mehrerer Runden der Glaubensverbreitung, die eine Nachricht umfasst, die die Glaubensnachrichten unter den Knoten weiterleitet, wobei die Glaubensverbreitungsrunden im Einklang mit dem verrauschten Codewort, wie empfangen, stehen,
- Durchführen mehrerer neuronaler Netzwerkrunden zwischen den Runden der Glaubensverbreitung, so dass Glaubensverbreitungsrunden mit neuronalen Netzwerkrunden alterniert werden, wobei jede neuronale Netzwerkrunde die Glaubensnachrichten gemäß einem neuronalen Graphennetzwerk (GNN) anpasst, wobei Knoten des neuronalen Graphennetzwerks den Knoten des grafischen Modells entsprechen,
- Berechnen einer Schätzung für jede Zufallsvariable aus den Glaubensnachrichten, die an den Knoten weitergeleitet werden, der die Zufallsvariable repräsentiert, und Verwenden der berechneten Schätzungen, um das verrauschte Codewort zu decodieren, wie es in das Codewort empfangen wird, wie es übertragen wird.

6. Neuronales Netzwerksystem nach Anspruch 5, wobei das Prozessorsystem ferner für Folgendes ausgebildet ist:

- Erhalten von Trainingsdaten, die Grundwahrheitsdaten für die Zufallsvariablen und beobachtete Daten für die Glaubensverbreitung umfassen,
- Erhalten von Werten trainierbarer Parameter für das eine oder die mehreren neuronalen Netzwerke,
- Durchführen des Verfahrens nach Anspruch 1 mit dem einen oder den mehreren neuronalen Netzwerken gemäß den Werten der trainierbaren Parameter,
- Durchführen eines Neuronalnetzwerk-Trainingsalgorithmus, um die trainierbaren Parameter gemäß den Trainingsdaten zu trainieren.

7. Flüchtiges oder nichtflüchtiges computerlesbares Medium (1000), das Anweisungen umfasst, die, wenn sie von einem Prozessorsystem ausgeführt werden, das Prozessorsystem veranlassen, das Verfahren nach einem der Ansprüche 1 bis 4 durchzuführen.

**Revendications**

1. Procédé mis en œuvre par ordinateur (500) pour estimer une pluralité de variables aléatoires ($X_i$), les variables

17

aléatoires et des dépendances locales parmi les variables aléatoires étant représentées dans un modèle graphique, le modèle graphique comprenant une pluralité de nœuds de variables correspondant à la pluralité de variables aléatoires et une pluralité de nœuds factoriels correspondant aux dépendances locales, le procédé comprenant

- la réception (505) d'un mot-code bruité sur un canal de communication en provenance d'un émetteur, un mot-code tel que transmis par l'émetteur sur le canal de communication étant représenté par la pluralité de variables aléatoires, des conditions de parité dans le mot-code tel que transmis étant représentées par les dépendances locales,
- la définition (510) d'une pluralité de messages de croyance ($\mu_a \rightarrow v(x_v)$, $\mu_{v \rightarrow a}(x_v)$) pour faire passer les messages entre les nœuds du modèle graphique dans un tour de propagation de croyance,
- le raffinement itératif des messages de croyance par l'exécution (520) de multiples tours de propagation de croyance (*BP*) comprenant le passage des messages de croyance parmi les nœuds $\left(\mu_{j \rightarrow i}^{(t)\prime} = BP(\mu_{j \rightarrow i}^{(t)})\right)$,

dans lequel les tours de propagation de croyance sont conformes au mot-code bruité tel que reçu,

- l'exécution (530) de multiples tours de réseau neuronal entre les tours de propagation de croyance $\left(\mu_{j \rightarrow i}^{(t+1)} = NN(\mu_{j \rightarrow i}^{(t)\prime})\right)$ de telle sorte que les tours de propagation de croyance alternent avec des tours de réseau neuronal, dans lequel chaque tour de réseau neuronal adapte les messages de croyance en fonction d'un réseau neuronal graphique (GNN), dans lequel des nœuds du réseau neuronal graphique correspondent aux nœuds du modèle graphique,
- le calcul (540) d'une estimation ($px_v(x_v) \propto \Pi_{a \in N(v)} \mu_{a \rightarrow v}(x_v)$) pour chaque variable aléatoire ($X_v$) à partir des messages de croyance passés au nœud (*v*) représentant la variable aléatoire, et l'utilisation des estimations calculées pour décoder le mot-code bruité tel que reçu dans le mot-code transmis.

2. Procédé selon la revendication 1, comprenant

- la définition (515) de données de nœud latentes ($h_i$) pour les multiples nœuds, un tour de réseau neuronal comprenant
- la mise à jour (532) des données de nœud latentes pour un nœud en fonction d'un ou plusieurs réseaux neuronaux à partir de : un message de croyance défini pour ce nœud, et/ou des données de nœud latentes pour ce nœud, et/ou des données de nœud latentes définies pour des nœuds environnants,
- l'adaptation (534) d'un message de croyance à partir de : des données de nœud latentes pour un nœud correspondant au message de croyance, et/ou une valeur précédente du message de croyance.

3. Procédé selon la revendication 2, dans lequel les données de nœud latentes sont initiées de façon aléatoire.

4. Procédé mis en œuvre par ordinateur (600) pour entraîner un ou plusieurs réseaux neuronaux, le procédé d'entraînement comprenant le procédé selon la revendication 1 et comprenant en outre

- l'obtention (610) de données d'entraînement comprenant des données de terrain pour les variables aléatoires et des données observées pour la propagation de croyance,
- l'obtention (620) de valeurs de paramètres pouvant être entraînés pour le ou les réseaux neuronaux,
- l'exécution (630) du procédé selon la revendication 1 avec le ou les réseaux neuronaux en fonction des valeurs des paramètres pouvant être entraînés,
- l'exécution (640) d'un algorithme d'entraînement de réseau neuronal pour entraîner les paramètres pouvant être entraînés en fonction des données d'entraînement.

5. Système de réseau neuronal pour estimer une pluralité de variables aléatoires, le système comprenant

- une mémoire de réseau neuronal configurée pour stocker des paramètres d'un ou plusieurs réseaux neuronaux,
- une mémoire de modèle configurée pour stocker une représentation d'un modèle graphique comportant de multiples nœuds, les multiples nœuds comprenant une pluralité de nœuds de variable correspondant à la pluralité de variables aléatoires et une pluralité de nœuds factoriels correspondant à des dépendances locales entre les variables aléatoires,
- une interface de communication configurée pour recevoir un mot-code bruité sur un canal de communication en

**EP 3 792 832 B1**

provenance d'un émetteur, un mot-code tel que transmis par l'émetteur sur le canal de communication étant représenté par la pluralité de variables aléatoires, des conditions de parité dans le mot-code tel que transmis étant représentées par les dépendances locales,

- un système de processeur configuré pour

- définir une pluralité de messages de croyance pour faire passer les messages entre les nœuds du modèle graphique dans un tour de propagation de croyance,

- raffiner de manière itérative les messages de croyance par l'exécution de multiples tours de propagation de croyance comprenant le passage des messages de croyance parmi les nœuds, dans lequel les tours de propagation de croyance sont conformes au mot-code bruité tel que reçu,

- exécuter de multiples tours de réseau neuronal entre les tours de propagation de croyance de telle sorte que les tours de propagation de croyance alternent avec des tours de réseau neuronal, dans lequel chaque tour de réseau neuronal adapte les messages de croyance en fonction d'un réseau neuronal graphique (GNN), dans lequel des nœuds du réseau neuronal graphique correspondent aux nœuds du modèle graphique,

- calculer une estimation pour chaque variable aléatoire à partir des messages de croyance passés au nœud représentant la variable aléatoire, et utiliser les estimations calculées pour décoder le mot-code bruité tel que reçu dans le mot-code transmis.

6. Système de réseau neuronal selon la revendication 5, dans lequel le système de processeur est en outre configuré pour

- obtenir des données d'entraînement comprenant des données de terrain pour les variables aléatoires et des données observées pour la propagation de croyance,

- obtenir des valeurs de paramètres pouvant être entraînés pour le ou les réseaux neuronaux,

- exécuter le procédé selon la revendication 1 avec le ou les réseaux neuronaux en fonction des valeurs des paramètres pouvant être entraînés,

- exécuter un algorithme d'entraînement de réseau neuronal pour entraîner les paramètres pouvant être entraînés en fonction des données d'entraînement.

7. Support transitoire ou non transitoire lisible par ordinateur (1000) comprenant des instructions qui, lorsqu'elles sont exécutées par un système de processeur, amènent le système de processeur à exécuter le procédé selon l'une quelconque des revendications 1 à 4.

Fig. 1a

Fig. 1b

*Fig. 1c*

*Fig. 1d*

*200*

221  222  223  224  225  226

231  232  233  234  235  236

241

211  212  213

## Fig. 2a

*201*

231  232  233  234  235  236

211  212  212

## Fig. 2b

*Fig. 2c*

*300*

*341*

*320*

*343*

*321*

*331*

*342*

*330*

*332*

*344*

*331*

Fig. 3a

*301*

*341*  →  320

*342*  →  330  →  332  *343*  →  320  *345* →

*344*  →  330  →  332  *346* →

*Fig. 3b*

302

341　343

320

322

324　326

321

331

342　344

330

332

Fig. 4

*Fig. 5*

*Fig. 6*

*1000*

*1010*

*1020*

# Fig. 7a

*1110*

*1130*

*1120*

*1122*

*1124*

*1126*

*1140*

# Fig. 7b

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- An iterative BP-CNN architecture for channel decoding. **LIANG et al.** J. Sel. Top. Signal Process. IEEE, 15 January 2018, vol. 12, 144-159
- **GARCIA SATORRAS et al.** Combining generative and discriminative models for hybrid inference. *arXiv:1906.02547v3*, 20 June 2019
- **YOON et al.** Inference in probabilistic graphical models by graph neural networks. *arXiv:1803.07710v5*, 27 June 2019
- **ZHANG et al.** Factor graph neural network. *arXiv:1906.00554v*, 03 June 2019